# EUROPEAN PATENT SPECIFICATION

(11) **EP 1 612 292 B1**
(45) Date of publication and mention of the grant of the patent: **21.05.2008**
(21) Application number: 04722457.1
(22) Date of filing: 22.03.2004
(51) Int. Cl.: C23C 14/34, B23K 20/12

(54) **SPUTTERING TARGET AND METHOD FOR PREPARATION THEREOF**
SPUTTERTARGET UND DESSEN HERSTELLUNGSVERFAHREN
CIBLE DE PULVERISATION CATHODIQUE ET SON PROCEDE DE PREPARATION

(30) Priority: 03.04.2003 JP 2003100782
(43) Date of publication of application: 04.01.2006
(73) Proprietor: Kobelco Research Institute, Inc., Kobe-shi, Hyogo 651-0073 (JP)
(72) Inventor: Matsumura, Hiromi, c/o Takasago Works, Takasago-shi, Hyogo 676-8670 (JP); Yoneda, Yoichiro, c/o Takasago Works, Takasago-shi, Hyogo 676-8670 (JP)
(74) Representative: TBK-Patent
(86) International application number: PCT/JP2004/003864
(87) International publication number: WO 2004/090194

(56) References cited:
- JP-A- 4 333 565
- JP-A- 7 062 528
- JP-A- 7 505 090
- JP-A- 9 508 073
- JP-A- 11 010 363
- JP-A- 11 061 393
- JP-A- 11 315 373
- JP-A- 2002 248 584
- JP-A- 2003 025 078
- US-A- 5 342 496
- US-A1- 2002 153 130
- LIU G. ET AL.: 'Microstructural aspects of the friction-stir welding of 6061-T6 aluminum' SCRIPTA MATERIALIA vol. 37, no. 3, 1997, pages 355 - 361, XP004324702
- RHODES C.G. ET AL.: 'Effects of friction stir welding on microstructure of 7075 aluminum' SCRIPTA MATERIALIA vol. 36, no. 1, 1997, pages 69 - 75, XP004324432

## Description

### Technical Field

The present invention relates to a sputtering target and a method for preparation thereof, and in particular, to a large sputtering target that can be used in the production of large liquid crystal displays or the like and a method for preparation thereof.

### Background Art

Recently, in order to increase the size of liquid crystal displays and to reduce the cost, liquid crystal panel manufacturers use a glass substrate having a dimension larger than 1 m square for the liquid crystal displays. In the future, as the increase in the size of displays advances, a glass substrate having a dimension of about 2 m square will also be used.

Wiring layers in a liquid crystal display are formed by sputtering. In the sputtering, a sputtering target (hereinafter also simply referred to as a target) having a dimension slightly larger than a glass substrate is generally used. For example, when a wiring layer is formed on a glass substrate having a dimension of about 1,100 mm x 1,250 mm, a very large target having a dimension of about 1,431 mm x 1,650 mm is used.

In general, sputtering must be satisfactorily performed without causing an abnormal discharge or the like, and in addition, a film having a uniform composition, a uniform thickness, and the like must be formed by sputtering. In order to satisfy these requirements, a sputtering target used must have a uniform composition, a uniform metallographic structure, and the like.

The production of a sputtering target generally includes a method of producing a metallic material and a method of processing the resultant metallic material to form a predetermined shape. Examples of the method of producing a metallic material include melting and casting, powder molding, and spray forming. Examples of the method of processing the resultant metallic material include hot isostatic pressing (HIP), forging, rolling, and machining and these methods are used in combination.

However, when a large sputtering target having a uniform composition and the like is produced, the following problems occur: Apparatuses may be limited in the above-described production, or when the sputtering target is produced with a large-scaled apparatus, a fine and uniform metallographic structure or the like cannot be obtained.

For example, in a sputtering target containing an intermetallic compound dispersed in the metallographic structure, the intermetallic compound is preferably dispersed finely and uniformly. When a metallic material is produced by melting and casting, in general, quenching the molten metallic material is required so as to disperse an intermetallic compound finely and uniformly. However, in producing a large target, a satisfactory quenching effect is difficult to be achieved because of an excessive amount of the molten material. Therefore, it is difficult to disperse the intermetallic compound finely and uniformly. In addition, the manufacturing apparatus is limited in view of, for example, the size and the shape of an ingot.

When a metallic material is produced by powder molding or spray forming, a subsequent HIP treatment is required to densify the metallic material. However, in producing a large metallic material, the size of the metallic material to be formed is disadvantageously limited because of the restriction of an apparatus for HIP.

Hitherto, in a trial for producing a large target (thickness: about 6 to about 20 mm), a method of welding two metal sheets with a welding rod has been studied. Also, electron beam welding, laser welding, and the like have been studied as welding methods that do not require a welding rod.

However, in these methods, the entrapment of a welding gas or the entrapment of an oxide formed on the surface of a metal sheet causes defects. In addition, the joined portion is melted and solidified, and consequently, the structure of crystal grains is coarsened, compared with the non-molten portion. Therefore, the use of such a target causes a problem of arcing during sputtering. Furthermore, in the above methods, the crystal grains are coarsened and the crystal orientation is also significantly changed at the same time. When such a target having an uneven crystal orientation is used in sputtering, the sputtering rate is changed. Consequently, a stable film thickness cannot be obtained.

### Disclosure of Invention

In view of the above situation, it is an object of the present invention to provide a method for preparation of a sputtering target wherein, even when the target is applied to a large sputtering target, the particle diameter and the dispersion state of metallic crystals or an intermetallic compound in a joined portion are approximately the same as those in a non-joined portion of the target.

A method for preparation of a sputtering target that can solve the above problems comprises a step of butt joining metal sheets being made of the same material by friction stir welding.

A friction stir welding (FSW) method is known in the art of joining metallic materials. For example, according to a document of "Behavior of oxide in joined portion during friction stir welding of aluminum alloy and its influences on mechanical properties" (Yousetsu Gakkai Ronbunshu (Quarterly Journal of the Japan Welding Society), August 2001, Vol. 19, No. 3, pp. 446-456), by this FSW method, an aluminum alloy is joined by a frictional heat caused by rotation between a rotating tool and a joining material and the plastic flow at a temperature lower than the melting point. Also, in the above document, from the viewpoint that an oxide film on the surface of the joining material is easily entrapped in the joined portion, a tensile test, a bending fatigue test, and the like in the joined portion were performed to investigate the effect of the oxide on the mechanical properties of the joined portion. The document describes the results of the mechanical properties.

According to a document of "FSW having an increasing number of applications" (Yousetsu Gijyutsu (Welding Technology), June 2002, pp. 67-78), the friction stir welding method is applied in the fields of ships and marine structures, railroad vehicles, space aeronautics, and the like, and high mechanical strength in a joined portion, which cannot be achieved by the conventional welding methods, can be ensured.

In these documents, the improvement of mechanical properties in a joined portion is investigated in order that a joined material is used as structural elements in the fields of ships and marine structures, railroad vehicles, space aeronautics, and the like. However, these studies do not target a sputtering target with which a satisfactory sputtering can be performed without causing an abnormal discharge, and a film having a uniform composition, thickness, and the like can be formed.

According to the document US 2002/0153130 A1, the friction stir welding method is used for joining together a cooling plate to which a target material for sputtering is joined. However, this document does not target butt joining.

In the present invention, during the butt joining, the moving distance of a rotating tool is preferably 0.3 to 0.45 mm per revolution. Annealing is preferably performed after the joining. Furthermore, in the present invention, a metallic material prepared by spray forming is preferably used because a sputtering target having a uniform composition and the like is easily produced.

Examples of the material of the metal sheets include one element selected from the group consisting of aluminum, an aluminum alloy, copper, a copper alloy, silver, and a silver alloy.

The present invention also includes a sputtering target prepared by the above method. The sputtering target according to the present invention has at least one of the following features (1) to (4).
(1) An intermetallic compound in a joined portion has an average particle diameter of 60% to 130% of the average particle diameter of the intermetallic compound in a non-joined portion.
(2) The average distance between adjacent intermetallic compound particles in a joined portion is 60% to 130% of the average distance between adjacent intermetallic compound particles in a non-joined portion.
(3) The average of the grain diameter of metallic crystals in a joined portion is 20% to 500% of the average of the grain diameter of metallic crystals in a non-joined portion.
(4) No dendritic structure is generated in a joined portion.

When the sputtering target of the present invention is applied to a target having a planar area of 1 m² or more, the advantages of the present invention can be satisfactorily exhibited.

### Brief Description of the Drawings

Fig. 1 is a schematic perspective view showing a friction stir welding method performed in Examples.
Fig. 2 is a schematic cross-sectional view showing a rotating tool used in Examples.
Fig. 3 is a cross-sectional view schematically showing the state of a joining material (i.e., metal sheet) after joining.

### Best Mode for Carrying Out the Invention

Under the above-described situation, the present inventors have investigated the particle diameter and the dispersion state of metallic crystals or an intermetallic compound in a joined portion and a non-joining portion of a sputtering target prepared by the butt joining of metal sheets being made of the same material. The investigation has been performed so that even when the target is applied to a large sputtering target, a satisfactory sputtering property is provided (for example, an abnormal discharge does not occur) during sputtering, and in addition, the resultant film has a uniform thickness and the like. As a result, the present inventors have found that the following requirements (1) to (4) should be satisfied.
(1) In a target containing an intermetallic compound dispersed in the metallographic structure, the intermetallic compound in a joined portion has an average particle diameter of 60% to 130% of the average particle diameter of the intermetallic compound in a non-joined portion.
   The reason for this is as follows. When the average particle diameter of the intermetallic compound in a joined portion exceeds 130% relative to that of the intermetallic compound in a non-joined portion, a large intermetallic compound is present in the joined portion, resulting in a problem of, for example, increasing in the variation in the film thickness during sputtering. The average particle diameter of the intermetallic compound in a joined portion is preferably 120% or less, more preferably, 110% or less of the average particle diameter of the intermetallic compound in a non-joined portion.
   When the size of the intermetallic compound in a joined portion is excessively smaller than that in a non-joined portion, the above problem occurs. Accordingly, the average particle diameter of the intermetallic compound in a joined portion is at least 60%, preferably at least 70%, and more preferably at least 80% of the average particle diameter of the intermetallic compound in a non-joined portion. In the most preferable case, the average particle diameter of the intermetallic compound in a joined portion is the same (100%) as the average particle diameter of the intermetallic compound in a non-joined portion.
(2) In a target containing an intermetallic compound dispersed in the metallographic structure, the average distance between adjacent intermetallic compound particles in a joined portion is 60% to 130% of the average distance between adjacent intermetallic compound particles in a non-joined portion.
   The reason for this is as follows. When the average distance between adjacent intermetallic compound particles in a joined portion exceeds 130% relative to the average distance between adjacent intermetallic compound particles in a non-joined portion, the intermetallic compound particles are sparsely dispersed. When a target having such a structure is used, the variation in the thickness of the resultant film is easily increased and a film having a uniform composition is not easily obtained. The average distance between adjacent intermetallic compound particles in a joined portion is preferably 120% or less, more preferably 110% or less, relative to the average distance between adjacent intermetallic compound particles in a non-joined portion.
   When the average distance between adjacent intermetallic compound particles in a joined portion is excessively smaller than the average distance between adjacent intermetallic compound particles in a non-joined portion, the above problem occurs. Accordingly, the average distance between adjacent intermetallic compound particles in a joined portion is at least 60%, preferably at least 70%, and more preferably at least 75% of the average distance between adjacent intermetallic compound particles in a non-joined portion. In the most preferable case, the average particle diameter of the intermetallic compound in a joined portion is the same (100%) as the average particle diameter of the intermetallic compound in a non-joined portion.
(3) In a target that does not contain an intermetallic compound in the metallographic structure, the average of the grain diameter of metallic crystals in a joined portion is 20% to 500% of the average of the grain diameter of metallic crystals in a non-joined portion.
   The reason for this is as follows. When the average of the grain diameter of metallic crystals in a joined portion exceeds 500% of the average of the grain diameter of metallic crystals in a non-joined portion, the metallic crystal grains in the joined portion are significantly coarsened, compared with those in the non-joined portion. When such a target is used in sputtering, the sputtering rate is changed. Consequently, for example, a stable film thickness cannot be obtained. The average of the grain diameter of metallic crystals in a joined portion is preferably 250% or less, more preferably 200% or less, of the average of the grain diameter of metallic crystals in a non-joined portion.
   When the grain diameter of metallic crystals in a joined portion is excessively smaller than the grain diameter of metallic crystals in a non-joined portion, the above problem occurs. Accordingly, the average of the grain diameter of metallic crystals in a joined portion is at least 20%, preferably at least 40%, and more preferably at least 50% relative to the average of the grain diameter of metallic crystals in a non-joined portion. In the most preferable case, the average of the grain diameter of metallic crystals in a joined portion is the same (100%) as the average of the grain diameter of metallic crystals in a non-joined portion.
(4) Regardless of the presence or absence of an intermetallic compound in the metallographic structure, no dendritic structure is generated in a joined portion.

In the butt joining of end faces of metal sheets by a known welding method, a dendritic structure is easily generated when a joined portion is melted is then solidified. The use of a target having such a structure is not preferable because the thickness of the resultant film is easily varied, and in addition, the composition of the film is not uniform.

For example, a sputtering target of the present invention is composed of one element selected from the group consisting of aluminum, an aluminum alloy, copper, a copper alloy, silver, and a silver alloy. Examples of the aluminum alloy, the copper alloy, and the silver alloy include alloys of aluminum, copper, or silver each containing an element such as a transition metal element; a rare earth element, e.g., Nd; or Bi in order to provide advantages such as heat resistance and corrosion resistance.

When the sputtering target of the present invention is used as a large target having a planar area of 1 m² or more, the advantages of the present invention can be satisfactorily exhibited. The shape of the target includes sheets having a planar area of a square, a rectangle, a circle, or an ellipse.

In order to produce a sputtering target prepared by the butt joining of metal sheets being made of the same material, wherein the particle diameter and the dispersion state of an intermetallic compound or the grain diameter of metallic crystals in a joined portion is approximately the same as those in a non-joined portion, it is very effective to use a friction stir welding method in the joining. Unlike conventional welding methods, in the friction stir welding method, as described above, a joined portion is not melted during joining and the plastic flow just occurs at a temperature lower than the melting point. Therefore, the coarsening of the metallic crystals in the joined portion is suppressed. Also, when an intermetallic compound is contained, the coarsening of the intermetallic compound is suppressed. Thus, a metallographic structure in the joined portion approximately the same as that in a non-joined portion can be provided.

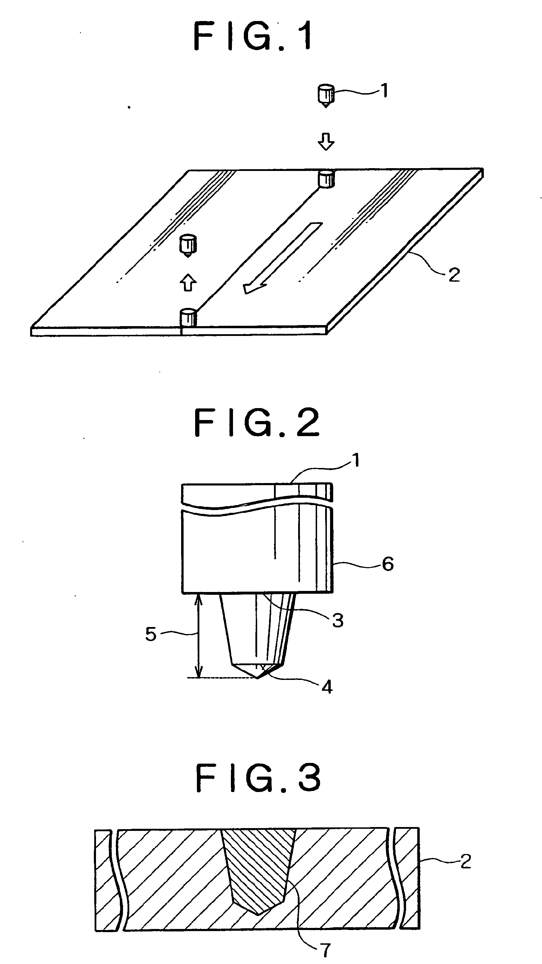

Specifically, for example, a friction stir welding is performed as follows. As shown in Fig. 1, which will be described below, a rotating tool 1 is screwed in a butted portion of materials 2 to be joined. The rotating tool 1 is composed of a material harder than that of the materials 2 to be joined. The rotating tool 1 is moved on the butted portion (i.e., joining line) of the materials 2 to be joined while rotating, thus generating frictional heat. The frictional heat softens a metal disposed at the peripheral part of the rotating tool 1 to generate a plastic flow. Thus, the materials 2 are joined.

As a condition for the above friction stir welding, the moving distance of the rotating tool used during joining is preferably 0.3 to 0.45 mm per revolution. When the moving distance per revolution of the rotating tool is excessively short, in other words, when the travel speed of the rotating tool is low and stirring at the same region becomes excessive, the temperature at the plastic flow region increases and a transformed structure is generated outside of the region. On the other hand, when the moving distance per revolution of the rotating tool is long, in other words, when the travel speed of the rotating tool is high, an excessive load is applied to the rotating tool and unevenness of processing is generated.

When a tool having a shape shown in Fig. 2, which will be described below, is used as the rotating tool, during joining, the rotating tool 1 is preferably tilted by 3° to 5° relative to the plane of the materials (metal sheets) 2 to be joined so that a part of shoulder 6 is tilted in the direction opposite to the traveling direction. In addition, the clearance between the materials 2 to be joined is preferably 0.03 mm or less during joining.

In the friction-stirred portion where a rotating tool has passed through during joining, the crystal orientation is changed because of the plastic flow. Therefore, a trace of stirring distinctly appears on the surface after sputtering. Accordingly, in order to prepare a target having a flat face and a good appearance, the target is preferably annealed so that the region that has been subjected to a high deformation by the plastic flow is recrystallized. Thus, the extreme change in the crystal orientation in the plastic flowing region should be reduced to remove the trace of stirring. From the viewpoint of improving the recrystallization and preventing the coarsening of crystal grains, the annealing is preferably performed at, for example, 200°C to 300°C for a pure aluminum target, 250°C to 500°C for an aluminum alloy target, 400°C to 500°C for a pure silver target, 450°C to 700°C for a silver alloy target, 400°C to 550°C for a pure copper target, and 450°C to 750°C for a copper alloy target. In order to completely remove the trace, the annealing time is preferably two hours or more. The annealing time is preferably 5 hours or less because an excessively long annealing time coarsens the crystal grain.

The metallic material used in the production of a sputtering target is preferably prepared by spray forming because the metallic material has more uniform composition or the like, compared with a metallic material prepared by casting or powder molding. In an example of the above spray forming method, a molten material is dropped from a nozzle having a diameter of a few millimeters, a gas such as N₂ gas is sprayed in the middle of dropping so as to pulverize the material, and an intermediate material (density: about 50% to about 60%) called a preform is formed before the powdery material is completely solidified.

The present invention does not specify the conditions for other production processes such as HIP, forging, and rolling, and these processes may be performed under normal conditions. In an example of a method for preparing a sputtering target, a metallic material prepared by the spray forming is densified with a HIP apparatus, and is then forged to form a metallic material sheet. Furthermore, the sheet is rolled so that the thickness of the sheet is approximately the same as that of the target to be formed. Subsequently, two metal sheets prepared by the same method are butted each other and are joined by friction stir welding as described above. According to this method, even a large target having a uniform particle diameter and uniform dispersion state of metallic crystals or an intermetallic compound can be prepared without limitation of apparatuses or the like.

### Examples

The present invention will now be described more specifically along with examples.

### <EXAMPLE 1>

### [Preparation of targets in Example (1) of the present invention]

An alloy material of A1-2 at% Nd was prepared by spray forming, and the alloy material was then densified by pressing at high temperature and high pressure. Subsequently, the resultant material was forged and rolled to prepare metal sheets each having a dimension of 13.5 mm (in thickness) x 730 mm x 1,710 mm. Two metal sheets having the same dimension were prepared. As shown in Fig. 1, the sides of 1,710 mm were butted and joined by friction stir welding.

The friction stir welding was performed as follows. Specifically, as shown in Fig. 2, a rotating tool 1 in which the diameter of a large diameter part 3 was 10 mm, the diameter of a small diameter part 4 was 8 mm, a rotating tool length 5 was 12.5 mm, and the diameter of a shoulder 6 was 20 mm was used in the joining.

During joining, the rotating tool 1 was tilted by 4° relative to the plane of materials (metal sheets) 2 to be joined so that the part of the shoulder 6 was tilted in the direction opposite to the traveling direction. In this state, the rotating tool 1 was screwed in a butted portion of the two materials (metal sheets) 2 to be joined. As shown in Fig. 1, the rotating tool 1 was moved on the butted portion of the materials 2 to be joined while rotating.

The revolution speed of the rotating tool 1 was 1,000 rpm, and the traveling speed of the rotating tool 1 was 400 mm/min (accordingly, the moving distance per revolution of the rotating tool 1 was 0.4 mm). As shown in Fig. 3, the height of the rotating tool 1 was adjusted so that the depth of a plastic flow portion 7 was about 13 mm and the remaining portion, which was not joined, was about 0.5 mm in the thickness of the sheet of 13.5 mm.

The calculated dimension of the sheet after joining was 13.5 mm (in thickness) x 1,460 mm x 1,710 mm. However, a portion where the rotating tool 1 was inserted (i.e., the initial portion of joining) and a portion where the rotating tool 1 was pulled out (i.e., the end portion of joining) could not be used as a product because these portions were regions processed by excessive heat. Consequently, the effective dimension of the metal sheet after joining was 13.5 mm (in thickness) x 1,460 mm x about 1,680 mm.

Subsequently, the joined metal sheet was annealed in a heat-treating furnace at 450°C for 2 hours. Another joined metal sheet that was not annealed was also prepared. In each of the metal sheets, 1 mm of the joined surface and 2.5 mm of the other surface including the remaining portion, which was not joined, were ground. Thus, targets each having a thickness of about 10 mm were prepared.

### [Observation of structure of target in Example (1) of the present invention]

The surface (of the joined side) of the resultant target (the annealed target) was observed with an electron microscope. In a non-joined portion on the surface, 30 intermetallic compound particles were observed per field of view. Also, in a joined portion on the surface, 30 intermetallic compound particles were observed per field of view. The particle diameters of intermetallic compound particles each having a diameter of at least 1 µm, and the nearest-neighbor distances between intermetallic compound particles each having a diameter of at least 1 µm were measured to calculate each average. Table 1 shows the results.

**Table 1**

| No. | Example (1) of the present invention | | | | Comparative Example (1) | |
|---|---|---|---|---|---|---|
| | Non-joined portion | | Joined-portion | | Molten portion | |
| | Diameter (µm) of intermeta llic compound particle | Distance (µm) to the nearest intermeta llic compound particle | Diameter (µm) of intermeta llic compound particle | Distance (µm) to the nearest intermeta llic compound particle | Diameter (µm) of intermeta llic compound particle | Distance (µm) to the nearest intermeta llic compound particle |
| 1 | 1.75 | 10.25 | 1.25 | 1.25 | 93.9 | 81.8 |
| 2 | 2 | 3.75 | 1.5 | 1.25 | 21.2 | 51.5 |
| 3 | 1.25 | 4.25 | 1.25 | 8.5 | 61 | 24.2 |
| 4 | 1.75 | 6.25 | 1.5 | 5.25 | 12.1 | 21.2 |
| 5 | 1.25 | 5.75 | 1.5 | 5.25 | 139.4 | 30.3 |
| 6 | 2.25 | 5.75 | 1.5 | 1.75 | 21.2 | 30.3 |
| 7 | 1.5 | 5.75 | 1.25 | 1.75 | 21.2 | 45.5 |
| 8 | 1.5 | 2.75 | 1 | 4 | 24.2 | 30.3 |
| 9 | 1 | 5.75 | 1 | 1.75 | 66.7 | 30.3 |
| 10 | 1.5 | 1 | 1.5 | 1.75 | 9.1 | 18.2 |
| 11 | 1.25 | 1 | 1.25 | 3 | 15.2 | 18.2 |
| 12 | 1.25 | 1.75 | 1 | 3 | 24.2 | 33.3 |
| 13 | 1.75 | 1.75 | 1 | 1.75 | 15.2 | 30.3 |
| 14 | 1.25 | 4.75 | 1.5 | 1.75 | 30.3 | 24.2 |
| 15 | 1.5 | 4 | 1.75 | 2.75 | 24.2 | 33.3 |
| 16 | 1.5 | 4 | 1 | 1.5 | 51.5 | 24.2 |
| 17 | 1.25 | 1.5 | 1.75 | 1.5 | 27.3 | 15.2 |
| 18 | 1.5 | 1.5 | 1.25 | 2.75 | 30.3 | 15.2 |
| 19 | 1.5 | 4.75 | 1.5 | 4.5 | 24.2 | 18.2 |
| 20 | 1.5 | 4.5 | 1 | 1 | 21.2 | 30.3 |
| 21 | 1.5 | 4.5 | 1 | 1 | 15.2 | 33.3 |
| 22 | 1.5 | 5 | 1.25 | 2.75 | 18.2 | 30.3 |
| 23 | 1.5 | 2.25 | 1.5 | 2.75 | 24.2 | 27.3 |
| 24 | 1.25 | 1 | 1.25 | 3.25 | 15.2 | 27.3 |
| 25 | 1.25 | 8 | 1 | 3.25 | 45.5 | 27.3 |
| 26 | 1.5 | 3.25 | 1.25 | 11.25 | 21.2 | 26.7 |
| 27 | 2 | 8.25 | 1.25 | 3.25 | 24.2 | 18.2 |
| 28 | 1.5 | 11.5 | 1.5 | 7.75 | 15.2 | 15.2 |
| 29 | 1.25 | 1.75 | 1 | 3 | 15.2 | 24.2 |
| 30 | 1.5 | 1.75 | 1 | 3.5 | 51.5 | 33.3 |
| Average | 1.5 | 4.3 | 1.3 | 3.3 | 32.6 | 29 |

As shown in Table 1, the average diameter of the intermetallic compound particles each having a diameter of at least 1 µm in the non-joined portion was 1.5 µm, whereas that in the joined portion was 1.3 µm. The average diameter of the intermetallic compound particles in the joined portion was 87% of the average diameter of the intermetallic compound particles in the non-joined portion.

The average distance between intermetallic compound particles each having a diameter of at least 1 µm in the non-joined portion was 4.3 µm, whereas that in the joined portion was 3.3 µm. The average distance between adjacent intermetallic compound particles in the joined portion was 77% of the average distance between those in the non-joined portion.

These results showed that the average diameter of the intermetallic compound particles and the average distance between intermetallic compound particles in the joined portion were approximately the same as those in the non-joined portion.

### [Sputtering experiment using targets in Example (1) of the present invention]

Sputtering was performed using the above annealed target and the target that was not annealed, and the surfaces after sputtering were observed. The sputtering was performed with a DC magnetron sputtering apparatus. During sputtering, the pressure of argon gas was 2 mTorr, the power (electric power) density was 6.4 W/cm², and the distance between a substrate and the target was 62 mm. Sputtering was performed under these conditions for 3 hours, the surface of each target was then visually observed. The result showed that, on the annealed target, the trace of the rotating tool was reduced, compared with the trace of the rotating tool on the target that was not annealed.

In addition, in order to evaluate the sputtering stability, the count of abnormal discharges was measured. As a result, the count of abnormal discharges in this example was smaller than that in Comparative Example (1), which will be described below. Furthermore, in films formed with the targets of the present invention, the variation in the film thickness was within the range of the average ± 3%. Thus, films having an approximately uniform thickness were formed.

### [Preparation of target in Comparative Example (1)]

A sputtering target was prepared as in Example 1 including annealing except that the joining was performed by electron beam (EB) welding. In the EB welding, the degree of vacuum was 1 x 10⁻⁴ Torr, a negative electrode having a diameter of 4 mm was used, the accelerating voltage was 60 kV, the beam current was 75 mA, and the welding speed was 400 mm/min.

### [Observation of structure of target in Comparative Example (1)]

The surface (of the joined side) of the sputtering target (the annealed target) prepared by joining by electron beam welding was observed with an electron microscope as in Example (1) of the present invention. The average of particle diameters of intermetallic compound particles each having a diameter of at least 1 µm and the average of nearest-neighbor distances between intermetallic compound particles each having a diameter of at least 1 µm were calculated. Table 1 includes the results.

Referring to Table 1, the average diameter of the intermetallic compound particles each having a diameter of at least 1 µm in the non-joined portion was 1.5 µm, whereas that in a joined portion (i.e., molten portion) was 32.6 µm. The average diameter of the intermetallic compound particles in the joined portion (molten portion) exceeded 20 times (2,000%) of the average diameter of intermetallic compound particles in the non-joined portion. This result showed that the coarsening significantly proceeded.

The average distance between intermetallic compound particles each having a diameter of at least 1 µm in the non-joined portion was 4.3 µm, whereas that in the joined portion (molten portion) was 29 µm. The average distance between adjacent intermetallic compound particles in the joined portion (molten portion) was 674% of the average distance between those in the non-joined portion. Thus, the intermetallic compound particles were significantly sparsely dispersed. In addition, it was confirmed that a part of the structure in the joined portion (molten portion) was a dendritic structure.

### [Sputtering experiment using target in Comparative Example (1)]

In order to evaluate the sputtering stability, the count of abnormal discharges was measured. In the same integral discharging power consumption as that in Example (1) of the present invention, the count of abnormal discharges was larger than that in Example (1) of the present invention. The possible reason was that the surface of the target in Comparative Example (1) had large irregularities because of the coarsening of the intermetallic compound.

In a film formed with the target in Comparative Example (1), the variation in the film thickness was represented by the average ± 5%, which was larger than that in Example (1) of the present invention.

### <EXAMPLE 2>

### [Preparation of targets in Example (2) of the present invention]

Next, targets were prepared using a material in which an intermetallic compound was not precipitated. In this experiment, an alloy material of Ag-1 at% Bi-0.9 at% Cu was prepared by melting and casting. The resultant material was forged and rolled to prepare metal sheets for joining each having a dimension of 11 mm (in thickness) x 650 mm x 1,180 mm. As in Fig. 1, the sides of 1,180 mm of the two metal sheets were butted and joined by friction stir welding under the same conditions as those in Example 1.

The calculated dimension of the sheet after joining was 13.5 mm (in thickness) x 1,180 mm x 1,300 mm. However, a portion where the rotating tool 1 was inserted (i.e., the initial portion of joining) and a portion where the rotating tool 1 was pulled out (i.e., the end portion of joining) could not be used as a product. Consequently, the effective dimension of the metal sheet after joining was 13.5 mm (in thickness) x 1,180 mm x about 1,270 mm.

Subsequently, the joined metal sheet was annealed in a heat-treating furnace at 450°C for 2 hours. Another joined metal sheet that was not annealed was also prepared. In each of the metal sheets, 1 mm of the joined surface and 2.5 mm of the other surface including the remaining portion, which was not joined, were ground. Thus, targets having a thickness of about 10 mm were prepared.

### [Observation of structure of target in Example (2) of the present invention]

The surface (of the joined side) of the resultant target (the annealed target) was observed with an electron microscope. The length of major axis and the length of minor axis of metallic crystals were measured. In a non-joined portion on the surface, 30 metallic crystals were measured. Also, in a joined portion on the surface, 30 metallic crystals were measured. The average calculated from the length of major axis and the length of minor axis was defined as a crystal grain diameter. Table 2 shows the results.

**Table 2**

| No. | Example (2) of the present invention | | Comparative Example (2) |
|---|---|---|---|
| | Non-joined portion | Joined-portion | Molten portion |
| | Crystal grain diameter (µm) | Crystal grain diameter (µm) | Crystal grain diameter (µm) |
| 1 | 31.6 | 135 | 925 |
| 2 | 50 | 140 | 1,295 |
| 3 | 48.7 | 65.6 | 1,203 |
| 4 | 63.1 | 124 | 879 |
| 5 | 36.8 | 141 | 463 |
| 6 | 55.2 | 57 | 1,249 |
| 7 | 43.4 | 113 | 786 |
| 8 | 68.4 | 110 | 1,008 |
| 9 | 52.6 | 91.2 | 749 |
| 10 | 42.1 | 102 | 867 |
| 11 | 73.6 | 104 | 348 |
| 12 | 50 | 71.3 | 888 |
| 13 | 51.3 | 89.8 | 1,036 |
| 14 | 65.8 | 162 | 1,129 |
| 15 | 52.6 | 102 | 944 |
| 16 | 73.6 | 107 | 1,055 |
| 17 | 44.7 | 150 | 759 |
| 18 | 57.9 | 74.8 | 490 |
| 19 | 50 | 77 | 592 |
| 20 | 23.7 | 110 | 833 |
| 21 | 34.2 | 75.5 | 1,064 |
| 22 | 21 | 147 | 842 |
| 23 | 36.8 | 152 | 666 |
| 24 | 44.7 | 81.2 | 676 |
| 25 | 55.2 | 117 | 574 |
| 26 | 27.6 | 101 | 786 |
| 27 | 35.5 | 145 | 944 |
| 28 | 26.3 | 72.8 | 916 |
| 29 | 44.7 | 69.8 | 1,101 |
| 30 | 27.6 | 123 | 638 |
| Average | 46.3 | 107 | 856.8 |

As shown in Table 2, the average of the grain diameter of metallic crystals in the non-joined portion was 46.3 µm, whereas that in the joined portion was 107 µm. Accordingly, the average of the grain diameter of metallic crystals in the joined portion was 231% of the average of that in the non-joined portion. This result showed that the coarsening was suppressed, compared with that in Comparative Example (2), which will be described below.

### [Sputtering experiment using target in Example (2) of the present invention]

In order to evaluate the sputtering stability, the count of abnormal discharges was measured. In the same integral discharging power consumption as that in the following Comparative Example (2), the count of abnormal discharges was smaller than that in Comparative Example (2). Furthermore, when sputtering was performed with the target of the present invention, the variation in the film thickness was represented by the average ± 5%. A film having more uniform thickness was obtained, compared with a film in the following Comparative Example (2).

### [Preparation of target in Comparative Example (2)]

A sputtering target was prepared as in Example (2) of the present invention except that the joining was performed by electron beam (EB) welding. The EB welding was performed under the same conditions as those in Comparative Example (1).

### [Observation of structure of target in Comparative Example (2)]

The surface (of the joined side) of the resultant sputtering target (the annealed target) was observed with an electron microscope as in Example (2) of the present invention. The length of major axis and the length of minor axis of each metallic crystal were measured, and the average thereof was defined as a crystal grain diameter. Table 2 includes the results.

Referring to Table 2, the average of the grain diameter of metallic crystals in the non-joined portion was 46.3 µm, whereas that in a joined portion (molten portion) was 857 µm. The average of the grain diameter of metallic crystals in the joined portion (molten portion) was about 20 times (1,851%) of the average of that in the non-joined portion. This result showed that the coarsening significantly proceeded.

### [Sputtering experiment using target in Comparative Example (2)]

In order to evaluate the sputtering stability, the count of abnormal discharges was measured. In the same integral discharging power consumption as that in Example (2) of the present invention, the count of abnormal discharges was larger than that in Example (2) of the present invention. The possible reason was that the surface of the target in Comparative Example (2) had large irregularities because of the coarsening of crystal grains. As a result, the abnormal discharges were increased.

In a film formed with the target in Comparative Example (2), the variation in the film thickness was represented by the average ± 10%, which was larger than that in Example (2) of the present invention.

### Industrial Applicability

The present invention is constituted as described above and can provide a sputtering target prepared by the butt joining of metal sheets being made of the same material. Even when the target is applied to a large sputtering target, the particle diameter and the dispersion state of metallic crystals or an intermetallic compound in a joined portion are approximately the same as those in a non-joined portion of the target.

The realization of this large sputtering target having a uniform structure allows large liquid crystal displays with high performance to be produced.

## Claims

1. A method for preparation of a sputtering target comprising a step of butt joining metal sheets (2) being made of the same material,
**characterized in that**
the butt joining is performed by friction stir welding.

2. The method for preparation of a sputtering target according to claim 1, wherein the moving distance of a rotating tool (1) is 0.3 to 0.45 mm per revolution to perform the butt joining.

3. The method for preparation of a sputtering target according to claim 1 or 2, wherein annealing is performed after the butt joining.

4. The method for preparation of a sputtering target according to any one of claims 1 to 3, wherein metal sheets (2) prepared by spray forming are used.

5. The method for preparation of a sputtering target according to any one of claims 1 to 4, wherein the material of the metal sheets (2) comprises one element selected from the group consisting of aluminum, an aluminum alloy, copper, a copper alloy, silver, and a silver alloy.

6. A sputtering target having a butt-welded joined portion (7), said sputtering target being obtainable by the method according to any one of claims 1 to 5 and **characterized by** at least one of the following features:
(1) an intermetallic compound in the joined portion (7) has an average particle diameter of 60% to 130% of the average particle diameter of the intermetallic compound in the non-joined portion;
(2) the average distance between adjacent intermetallic compound particles in the joined portion (7) is 60% to 130% of the average distance between adjacent intermetallic compound particles in the non-joined portion;
(3) the average of the grain diameter of metallic crystals in the joined portion (7) is 20% to 500% of the average of the grain diameter of metallic crystals in the non-joined portion; and
(4) no dendritic structure is generated in the joined portion (7).

7. The sputtering target according to claim 6, comprising a planar area of 1 m² or more.

## Patentansprüche

1. Verfahren zur Herstellung eines Sputter-Targets mit dem Schritt Stumpfstoßverbinden von Metalltafeln (2), die aus dem gleichen Material bestehen,
**dadurch gekennzeichnet, dass**
das Stumpfstoßverbinden durch Reibrührschweißen erfolgt.

2. Verfahren zur Herstellung eines Sputter-Targets nach Anspruch 1, wobei die Bewegungsstrecke eines Drehwerkzeugs (1) 0,3 bis 0,45 mm pro Umdrehung beträgt, um das Stumpfstoßverbinden durchzuführen.

3. Verfahren zur Herstellung eines Sputter-Targets nach Anspruch 1 oder 2, wobei nach dem Stumpfstoßverbinden ein Glühen erfolgt.

4. Verfahren zur Herstellung eines Sputter-Targets nach einem der Ansprüche 1 bis 3, wobei durch Sprühformen hergestellte Metalltafeln (2) verwendet werden.

5. Verfahren zur Herstellung eines Sputter-Targets nach einem der Ansprüche 1 bis 4, wobei das Material der Metalltafeln (2) ein Element umfasst, das aus der aus Aluminium, einer Aluminiumlegierung, Kupfer, einer Kupferlegierung, Silber und einer Silberlegierung bestehenden Gruppe gewählt ist.

6. Sputter-Target mit einem im Stumpfstoß geschweißten verbunden Abschnitt (7), das durch das Verfahren gemäß einem der Ansprüche 1 bis 5 erhältlich ist und durch mindestens eines der folgenden Merkmale **gekennzeichnet** ist:
(1) eine intermetallische Verbindung in dem verbundenen Abschnitt (7) hat einen mittleren Teilchendurchmesser von 60% bis 130% des mittleren Teilchendurchmessers der intermetallischen Verbindung in dem unverbundenen Abschnitt;
(2) der mittlere Abstand zwischen benachbarten intermetallischen Verbindungsteilchen in dem verbundenen Abschnitt (7) beträgt 60% bis 130% des mittleren Abstands zwischen benachbarten intermetallischen Verbindungsteilchen in dem unverbundenen Abschnitt;
(3) der Mittelwert des Korndurchmessers von Metallkristallen in dem verbundenen Abschnitt (7) beträgt 20% bis 500% des Mittelwerts des Korndurchmessers von Metallkristallen in dem unverbundenen Abschnitt; und
(4) in dem verbundenen Abschnitt (7) ist keine Dendritstruktur entstanden.

7. Sputter-Target nach Anspruch 6 mit einer Planfläche von 1 m² oder mehr.

## Revendications

1. Procédé de préparation d'une cible de métallisation par pulvérisation cathodique sous vide comprenant une étape consistant à aboucher des feuilles de métal (2) faites du même matériau,
**caractérisé en ce que**
l'abouchement est réalisé par soudage par friction.

2. Procédé de préparation d'une cible de métallisation par pulvérisation cathodique sous vide selon la revendication 1, dans lequel la distance de déplacement d'un outil rotatif (1) est de 0,3 à 0,45 mm par tour pour réaliser l'abouchement.

3. Procédé de préparation d'une cible de métallisation par pulvérisation cathodique sous vide selon la revendication 1 ou 2, dans lequel un recuit de stabilisation est réalisé après l'abouchement.

4. Procédé de préparation d'une cible de métallisation par pulvérisation cathodique sous vide selon l'une quelconque des revendications 1 à 3, dans lequel on utilise des feuilles de métal (2) préparées par procédé de dépôt par pulvérisation.

5. Procédé de préparation d'une cible de métallisation par pulvérisation cathodique sous vide selon l'une quelconque des revendications 1 à 4, dans lequel le matériau des feuilles de métal (2) comprend un élément choisi parmi le groupe constitué par l'aluminium, un alliage d'aluminium, le cuivre, un alliage de cuivre, l'argent, et un alliage d'argent.

6. Cible de métallisation par pulvérisation cathodique sous vide ayant une partie jointe par abouchement (7), ladite cible de métallisation par pulvérisation cathodique sous vide pouvant être obtenue par le procédé selon l'une quelconque des revendications 1 à 5 et **caractérisée par** au moins une des caractéristiques suivantes :
(1) un composé métallique dans la partie jointe (7) a un diamètre de particule moyen égal à 60 % à 130 % du diamètre de particule moyen du composé intermétallique dans la partie non-jointe ;
(2) la distance moyenne entre les particules de composé intermétallique adjacentes dans la partie jointe (7) est égale à 60 % à 130 % de la distance moyenne entre les particules de composé intermétallique adjacentes dans la partie non-jointe ;
(3) la moyenne du diamètre de grain des cristaux métalliques dans la partie jointe (7) est égale à 20 % à 500 % de la moyenne du diamètre de grain des cristaux métalliques dans la partie non-jointe ; et
(4) aucune structure dendritique n'est générée dans la partie jointe (7).

7. Cible de métallisation par pulvérisation cathodique sous vide selon la revendication 6, comprenant une aire plane de 1 m² ou plus.
